(19) **Europäisches Patentamt**
**European Patent Office**
**Office européen des brevets**

(11) **EP 1 168 626 B1**

(12) **EUROPÄISCHE PATENTSCHRIFT**

(45) Veröffentlichungstag und Bekanntmachung des Hinweises auf die Patenterteilung:
**23.05.2007 Patentblatt 2007/21**

(51) Int Cl.:
*H03L 3/00* (2006.01)    *H03B 11/10* (2006.01)

(21) Anmeldenummer: **01113474.9**

(22) Anmeldetag: **02.06.2001**

(54) **Verfahren zur Reduzierung der Abkling- und Einschwingzeiten bei Schwingkreisen**

Method for reducing the settling and rise times in oscillating circuits

Méthode de réduction des temps d' établissement et de montée dans des circuits oscillants

(84) Benannte Vertragsstaaten:
**DE FR GB IT**

(30) Priorität: **24.06.2000 DE 10030952**

(43) Veröffentlichungstag der Anmeldung:
**02.01.2002 Patentblatt 2002/01**

(73) Patentinhaber: **ATMEL Germany GmbH
74072 Heilbronn (DE)**

(72) Erfinder: **Hanselmann, Dieter
74613 Öhringen (DE)**

(56) Entgegenhaltungen:
**EP-A- 0 323 794        US-A- 3 646 477
US-A- 4 453 162        US-A- 4 617 534
US-A- 5 517 158**

**Beschreibung**

Die vorliegende Erfindung betrifft ein Verfahren zur Reduzierung der Abkling- und Einschwingzeiten bei Schwingkreisen, gemäß dem Oberbegriff des Patentanspruchs 1.

Bei im intermittierenden Betrieb arbeitenden Schwingkreisen wird die Erregerspannung schnell ein und ausgeschaltet. Neben diesen beiden stabilen Zuständen, sind Übergangszustände vorhanden, während deren die Amplitude der Schwingung abklingt oder wieder aufgebaut wird. Je schneller in einem gegebenen Zeitraum die Schaltvorgänge stattfinden, desto größer wird der Anteil der Zeiten in denen die Schwingung abklingt oder wieder anschwingt im Verhältnis zu den Zeiten in denen sich der Schwingkreis in einem stabilen Zustand befindet. Um den zeitlichen Anteil der Übergangszustände zu berechnen, ergibt sich mit einer exponentiellen Beschreibung für das Abklingverhalten der Spannungsverlauf im Schwingkreis zu:

$$U = U_{max} \cdot \exp(n \cdot \pi / Q) \qquad (1)$$

wobei n die Periodenzahl und Q die Güte des Schwingkreises ist. Aus der Annahme daß die Schwingung abgeklungen ist, sofern die Amplitude auf 10% des Maximalwert abgesunken ist, ergibt sich die dafür notwendige Periodenzahl für eine Güte von Q = 14 aus der Gleichung (2) zu mindestens 10 Perioden:

$$n = Q / \pi \cdot | \ln(U / U_{max}) | = 14 / \pi \cdot | \ln(10\% / 100\%) | = 10 \qquad (2)$$

Ferner zeigt die Gleichung (2), daß mit steigender Güte die notwendige Periodenzahl ebenfalls linear steigt. Aus der Frequenz des Schwingkreises von Beispielsweise 100 kHz ergibt sich eine Abklingzeit von 100 $\mu$s. Bei Berücksichtigung der Anschwingzeit verdoppelt sich diese auf 200 $\mu$s, sofern für die Anschwingzeit näherungsweise der gleiche funktionale Zusammenhang wie für die Berechnung der Abklingzeit zugrunde gelegt wird.

Ein wichtiges Anwendungsgebiet von Systemen mit intermittierenden Betrieb arbeitenden Schwingkreisen sind Sende- und Empfangseinheiten mit denen Daten übertragen werden. Hierzu wird in den Sendeeinheiten der Schwingkreis ein und ausgeschaltet. Alle Abkling- und Anschwingzeiten des Schwingkreises verringern die Datenübertragungsrate, da die Sendelücken vergrößert werden. Bei einer Frequenz von beispielsweise einigen 100 kHz liegt im Fall der digitalisierten Datenübertragung die Zeit der stabilen Zustände in der Größenordnung der Zeiten der Übergangszustände. Für die Anwendung im Bereich der kontaktlosen Identifikation, insbesondere im Automobilbereich für den Authentifizierungsprozeß von Transponder und Basiseinheit, ist eine hohe Datenübertragungsrate sehr wichtig, da für den Gesamtprozeß nur eine Zeitspanne von maximal 150 ms zur Verfügung steht. Wird der Transponder von der Basiseinheit auf induktiven Wege mit Energie versorgt, vergrößern sich durch die Übergangszustände der Schwingkreise die Zeiten, in denen der Transponder keine Energie aus dem' Feld der Basiseinheit aufnehmen kann.

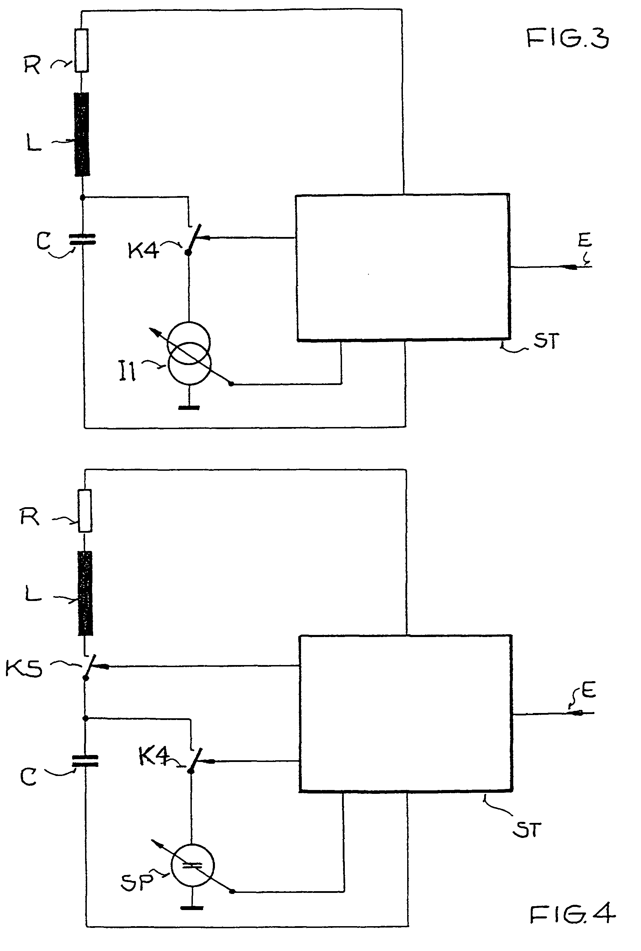

Verfahren, die nach dem bisherigen Stand der Technik arbeiten sind beispielsweise aus dem Datenbuch TEMIC Semiconductor GmbH 1999 S. 404 Figur 4 bekannt. Die abgebildete Schaltungsanordnung zur Umsetzung des Verfahrens wird im Bereich der kontaktlosen Identifikationssysteme zur Ansteuerung von Schwingkreisspulen in den Basiseinheiten eingesetzt, um die Daten und die Energie zu den Transpondern zu übertragen. Bei einer Schwingkreisfrequenz von 130 kHz liegen laut dem Datenbuch Seite 338 die Sendelücken der Basiseinheit zwischen 160 $\mu$s und 400 $\mu$s, abhängig von der Güte des eingesetzten Schwingkreises. Die Zeitdauer des Authentifizierungprozesses zwischen Transponder und Basiseinheit liegt bei mindestens bei 50 ms und steigt mit höherer Güte der verwendeten Sendekreise auf Werte bis 120 ms an.

Nachteil der bisherigen Verfahren zum Ansteuern der Schwingkreisen ist es, daß die Übergangszustände die Datenübertragungsraten bei den im intermittierenden Betrieb arbeitenden Schwingkreisen reduzieren. Im Bereich der kontaktlosen Identifikationssysteme ergeben sich dadurch erhöhte Zeiten für den Authentifizierungsprozeß. Erfolgt die Energieversorgung des Transponders auf induktiven Wege von der Basiseinheit, verringert sich durch die verlängerten Sendelücken der Energieübertrag auf den Transponder. Der Kommunikationsabstand zwischen Basiseinheit und Transponder, der im Bereich von wenigen cm liegt, wird damit verringert.

Die EP 0 323 794 A1 beinhaltet eine Schaltungsanordnung zum Erzeugen einer sinusförmigen Schwingung mit verkürzter Einschwingzeit, bei der wenigstens ein Kondensator und eine Spule einen Schwingkreis bilden, der im Schwingungszustand mittels einer ersten Stromquelle erregt und mittels eines ersten Transistors an- und abgeschaltet wird. Die Druckschrift schlägt die Verwendung einer zweiten Stromquelle und einer Anordnung von Schaltelementen vor, die einerseits mit einer Referenzspannung, andererseits mit einer Steuerspannung in Wirkverbindung stehen, sodass bei inaktivem Schwingkreis die Summe der Ströme beider Stromquellen durch die Spule fließt. Zum Starten der Schwingung wird die Steuerspannung unter die Referenzspannung abgesenkt, wodurch ein erstes Schaltelement leitend geschaltet und der Strom der ersten Stromquelle in den Schwingkreis eingekoppelt wird und diesen erregt. Gleichzeitig sorgen die weiteren Schaltelemente dafür, dass die zweite Stromquelle von dem Schwingkreis isoliert wird. Das vorstehend beschriebene vorbekannte Verfahren bedingt in seiner schaltungstechnischen Ausgestaltung eine relativ große Komplexität, was insbesondere in der Massenproduktion mit Kostennachteilen verbunden ist.

Die US 4,453,162 betrifft einen Sender für Telemetrie-Anwendungen. Ihr Gegenstand der weist einen Parallelschwingkreis aus Kondensator und Spule auf, der über einen zwischen dem Kondensator und der Spule liegenden Knoten mit einer Batterie verbunden ist. Zwischen dem Knoten und der Batterie ist weiterhin ein erstes elektrisches Schaltelement in Form eines Transistors angeordnet, das über den invertierten Q-Ausgang eines D-Flip-Flops gesteuert wird. Ein zweites Schaltelement befindet sich zwischen dem Kondensator und dessen Masseanschluss. Nach Maßgabe eines Steuersignals wird zunächst Transistor leitend geschaltet, sodass der Kondensator und die Spule einen geschlossenen Schwingkreis bilden, der mit seiner Eigenfrequenz zu schwingen beginnt. Sobald das Potential im Knoten seinen höchsten tatsächlich erreichbaren Wert annimmt, schaltet das Flip-Flop über den o.g. Ausgang den Transistor kurzzeitig leitend, sodass das Potential in und damit der Kondensator zum Ausgleichen von Verlusten des Schwingkreises auf den Wert der Batteriespannung hoch "gepumpt" wird, wobei der Schwingkreis zwischen zwei "Pumpvorgängen" jeweils etwa für eine volle Schwingungsperiode frei schwingt.

Die US 5,517,158 offenbart einen Schwingkreis mit Start- und Stoppschaltkreisen. Der Schwingkreis besteht im Wesentlichen aus einer Spule und einem mit dieser in Reihe geschalteten Kondensator, der durch impulsartiges Anstoßen in Schwingung versetzt wird. Zum Ausgleichen von Widerstandsverlusten ist ein Schaltkreis vorgesehen, sodass an einem zwischen Spule und Kondensator befindlichen Knoten ein Sinussignal mit Amplitude ausgegeben wird. Nach Maßgabe einer Steuereinheit lässt sich die Schwingung zu beliebigen Zeiten stoppen, indem beide Anschlüsse der Spule auf ein gemeinsames Potential gelegt werden, woraufhin nach einer gewissen Nachschwingzeit der Schwingkreis zur Ruhe kommt. Zugleich wird der Knoten dauerhaft auf das Potential gelegt, sodass - wiederum nach Maßgabe der Steuereinheit - ein neuer Schwingungszyklus unmittelbar beginnen kann.

Der Erfindung liegt die Aufgabe zugrunde, ein neuartiges Verfahren bzw. eine insbesondere zum Durchführen dieses Verfahrens geeignete Vorrichtung anzugeben, das bzw. die unter Vermeidung der vorstehend aufgeführten Nachteile zur Reduzierung sowohl der Abkling- als auch der Einschwingzeiten bei im intermittierenden Betreib arbeitenden Schwingkreisen geeignet ist, um so die Datenübertragungsrate zwischen Sende- und Empfangsanlagen zu erhöhen. Die Aufgabe wird durch das Verfahren nach Anspruch 1 bzw. die Schaltungsanordnung nach Anspruch 7 gelöst. Günstige Ausgestaltungsformen sind Gegenstand von Unteransprüchen.

Hiernach besteht das Wesen der Erfindung darin, beim Abschaltungen der Errregerspannung eines Schwingkreises, die Amplituden einer der physikalischen Größen die die Schwingung charakterisieren auf ihren Maximalwerten festzuhalten, bis die Errregerspannung des Schwingkreises wieder eingeschaltet wird. Dadurch kann der Schwingkreis unverzüglich mit der maximalen Amplitude der festgehaltenen Größe weiterschwingen. Untersuchungen der Anmelderin haben gezeigt, daß als charakteristische Größen der Strom oder die Spannung verwendet werden können und das Festhalten, im Folgenden Klemmung genannt, einer dieser Größen sowohl bei parallelen als auch bei seriellen Schwingkreisen durchgeführt werden kann. Besonders vorteilhaft ist es, wenn die Schwingkreise mit ihrer Resonanzfrequenz erregt werden.

Als erstes wird das erfindungsgemäße Verfahren für den Fall, daß der Strom auf seinen Maximalwert geklemmt wird, erläutert. Von einer Steuereinheit, die den Schwingkreis erregt, wird beim Ausschalten der Erregerspannung, mittels eines von ihr angesteuerten Schaltelementes, eine Stromquelle mit der Spule des Schwingkreises verbunden, die den Strom durch die Spule auf seinen Maximalwert klemmt. Beim erneuten Einschalten der Erregerspannung wird von der Steuereinheit, mittels dem Schaltelement, die Verbindung zwischen der Stromquelle und dem Schwingkreis wieder aufgetrennt und der Schwingkreis kann unverzüglich mit seiner maximalen Amplitude weiterschwingen. Diese Ausführung ist besonders vorteilhaft, da durch die sperrende Eigenschaft des Kondensators der Schwingkreis zum Anklemmen der Stromquelle nicht aufgetrennt werden muß.

Eine weitere Umsetzung des erfindungsgemäßen Verfahrens läßt sich durch die Klemmung der Spannung realisieren. Hierzu wird von einer Steuereinheit, die den Schwingkreis erregt, beim Ausschalten der Erregerspannung mittels eines ersten Schaltelementes, die Verbindung zwischen Spule und Kondensator aufgetrennt und mittels eines zweiten Schaltelementes eine Spannungsquelle mit dem Kondensator verbunden, um die Spannung am Kondensator auf den Maximalwert zu klemmen. Beim erneuten Einschalten der Erregerspannung wird von der Steuereinheit, mittels des ersten Schaltelementes, die Verbindung zwischen der Spule und dem Kondensator wieder hergestellt und mittels des zweiten Schaltelementes die Spannungsquelle von dem Schwingkreis abgetrennt, damit der Schwingkreis unverzüglich mit seiner maximalen Amplitude weiterschwingen kann.

Nachfolgend wird die Erfindung anhand den Zeichnungen Figur 1 bis Figur 4 dargestellt und erläutert. Es zeigen:

Fig. 1    Eine erstes Ausführungsbeispiel der Erfindung zur Klemmung des Stromes in einem parallelen Schwingkreis,

Fig. 2    Ein zweites Ausführungsbeispiel der Erfindung zur Klemmung der Spannung in einem parallelen Schwingkreis,

Fig. 3    Eine drittes Ausführungsbeispiel der Erfindung zur Klemmung des Stromes in einem seriellen Schwingkreis,

Fig. 4    Ein letztes Ausführungsbeispiel der Erfindung zur Klemmung der Spannung in einem seriellen Schwingkreis.

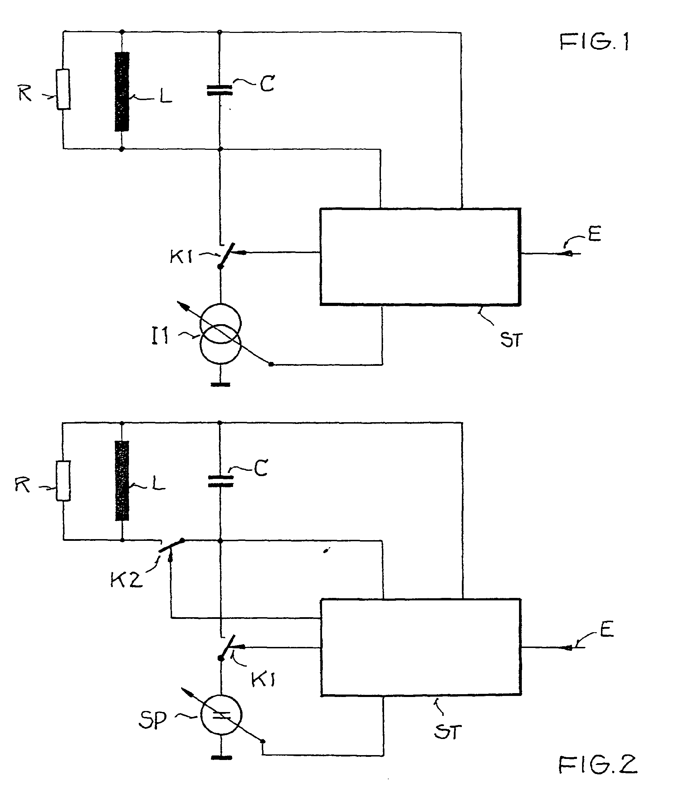

Das Blockschaltbild in Figur 1 zeigt eine erste vorteilhafte Realisierung des erfindungsgemäßen Verfahrens für einen parallelen Schwingkreis. Dieser besteht aus einer Spule L, einem Kondensator C und einem Widerstand R und wird von einer mit dem Schwingkreis verbundenen Steuereinheit ST mit seiner Resonanzfrequenz erregt. Ferner ist an den Schwingkreis ein Schaltelement K1, das eine an dem Bezugspotential angeschlossene steuerbare Stromquelle I1 mit dem Schwingkreis verbindet, angeschlossen. Die Steuereingänge der Stromquelle I1 und des Schaltelementes K1 sind jeweils mit der Steuereinheit ST verbunden. Des weiteren besitzt die Steuereinheit ST einen Eingang E, über den sie getriggert werden kann. Ausgangspunkt der Funktionsbeschreibung ist der Zustand, in dem die Steuereinheit ST den Schwingkreis mit seiner Resonanzfrequenz erregt. In diesem Zustand ist das Schaltelement K1 geöffnet. Wird die Steuereinheit ST mit einem Eingangssignal getriggert, schaltet diese zu dem Zeitpunkt die Erregung des Schwingkreises ab, in dem der Strom durch die Spule L seinen maximalen Wert erreicht hat. Gleichzeitig verbindet die Steuereinheit ST, mittels des Schaltelementes K1, die Stromquelle I1 mit dem Schwingkreis, um den Strom durch die Spule L auf den Maximalwert zu klemmen. Hierzu wird von der Steuereinheit ST der Strom der Stromquelle I1 so eingestellt, daß er der Summe der beiden Ströme durch den Widerstand R und der Spule L entspricht. Da Im Gleichspannungsfall der Kondensator C einen unendlich hohen Widerstand darstellt, ist der Stromfluß durch den Kondensator vernachlässigbar. Wird die Steuereinheit ST erneut mit einem Eingangssignal getriggert , wird die Stromquelle I1 von der Steuereinheit ST mittels dem Schaltelement K1 von dem Schwingkreis getrennt und die Erregung des Schwingkreises in dem Zeitpunkt fortgesetzt und der Schwingkreis kann mit seiner maximalen Amplitude weiterschwingen.

Das Blockschaltbild in Figur 2 zeigt für einen parallelen Schwingkreis eine weitere Ausführungsform des erfindungsgemäßen Verfahrens. Im Unterschied zu der in Figur 1 dargestellten Anordnung, wird anstelle des Stromes die Spannung des Schwingkreises geklemmt. Hierzu wird ein aus einer Spule L, einem Kondensator C und einem Widerstand R bestehender paralleler Schwingkreis von einer mit dem Schwingkreis verbundenen Steuereinheit ST mit seiner Resonanzfrequenz erregt. Um die Verbindung zwischen Spule L und dem Kondensator C auftrennen zu können, sind diese mittels einem Schaltelement K2 verbunden.

Ferner ist am Schwingkreis ein Schaltelement K1, das eine an dem Bezugspotential angeschlossene steuerbare Spannungsquelle SP mit dem Schwingkreis verbindet, angeschlossen. Die Steuereingänge der Spannungsquelle SP und des Schaltelementes K1 sind ihrerseits mit der Steuereinheit ST verbunden. Des weiteren besitzt die Steuereinheit ST einen Eingang E über den sie getriggert werden kann. Aufgabe der Steuereinheit ST ist es, wenn sie getriggert wurde, zu dem Zeitpunkt die Erregung des Schwingkreises abzuschalten, wenn die Spannung am Kondensator C den maximalen Wert erreicht hat und gleichzeitig mittels des Schaltelementes K1 die Spannungsquelle SP mit dem Schwingkreis zu verbinden und die Verbindung zwischen der Spule L einerseits und dem Kondensator C und dem Widerstand R andererseits zu lösen, damit kein Stromfluß über die beiden passiven Bauelemente stattfinden kann. Von der Steuereinheit ST wird die Spannung der Spannungsquelle SP entsprechend der Höhe der am Kondensator C anliegenden Spannung eingestellt. Wird die Steuereinheit ST erneut getriggert , wird durch das Schaltelement K1 die Spannungsquelle SP von dem Schwingkreis getrennt und mittels des Schaltelementes K2 die Verbindung zwischen dem Kondensator C der Spule L und dem Widerstand R wiederhergestellt und die Erregung des Schwingkreises in dem Zeitpunkt fortgesetzt, daß der Schwingkreis mit seiner maximalen Amplitude weiterschwingen kann. Sofern der Kondensator C nur sehr geringe Leckströme aufweist und die Erregung des Schwingkreises nur kurzzeitig ausgesetzt wird, kann das Anklemmen der Spannungsquelle SP entfallen. Unter diesen Bedingungen vereinfacht sich die Schaltungsanordnung erheblich.

Das Blockschaltbild in Figur 3 zeigt eine Realisierung des erfindungsgemäßen Verfahrens für einen seriellen Schwingkreis. Dieser besteht aus einem Widerstand R, einer Spule L und einem Kondensator C, die in einer Reihenschaltung verbunden sind und wird von einer mit dem Schwingkreis verbundenen Steuereinheit ST mit seiner Resonanzfrequenz erregt. Ferner ist an der Spule L und dem Kondensator C ein Schaltelement K4, das eine an dem Bezugspotential angeschlossene steuerbare Stromquelle I1 mit dem Schwingkreis verbindet, angeschlossen. Die Steuereingänge der Stromquelle I1 und des Schaltelementes K4 sind ihrerseits mit der Steuereinheit ST verbunden. Ferner weist die Steuereinheit ST einen Eingang E auf, über den sie getriggert werden kann. Aufgabe der Steuereinheit ST ist es, wenn sie mit einem Signal getriggert wurde, zu dem Zeitpunkt die Erregung des Schwingkreises abzuschalten, in dem der Strom durch die Spule L seinen maximalen Wert erreicht hat und gleichzeitig mittels des Schaltelementes K4 die Stromquelle I1 mit dem Schwingkreis zu verbinden, damit der Strom durch die Spule L auf diesem Wert geklemmt. Für den Gleichspannungsfall stellt der Kondensator C einen unendlich hohen Widerstand dar, weshalb der Stromfluß durch den Kondensator C vernachlässigt werden kann. Wird die Steuereinheit ST erneut getriggert, wird durch das Schaltelement K1 die Stromquelle I1 von dem Schwingkreis getrennt und die Erregung des Schwingkreises in dem Zeitpunkt fortgesetzt, daß der Schwingkreis mit seiner maximalen Amplitude weiterschwingt.

Das Blockschaltbild in Figur 4 zeigt für einen seriellen Schwingkreis eine weitere Realisierung des erfindungsgemäßen Verfahrens, wobei im Unterschied zu der in Figur 3 dargestellten Anordnung statt dem Strom nun die Spannung des Schwingkreises geklemmt wird. Hierzu wird ein aus einer Spule L, einem Kondensator C und einem Widerstand R bestehender serieller Schwingkreis von einer mit dem Schwingkreis verbundenen Steuereinheit ST mit seiner Resonanzfrequenz erregt. Um die Verbindung zwischen Spule L und dem Kondensator C auftrennen zu können, sind diese mittels einem Schaltelement K5 verbunden. Ferner ist mit dem Schwingkreis ein Schaltelement K4, das eine an dem Bezugspotential angeschlossene steuerbare Spannungsquelle SP mit dem Schwingkreis verbindet, angeschlossen. Die Steuereingänge der Spannungsquelle SP, des Schaltelementes K4 und des Schaltelementes K5 sind jeweils mit der Steuereinheit ST verbunden. Des weiteren besitzt die Steuereinheit ST einen Eingang E über den sie getriggert werden kann. Aufgabe der Steuereinheit ST ist es, wenn sie getriggert wurde, zu dem Zeitpunkt die Erregung des Schwingkreises abzuschalten, bei dem die Spannung am Kondensator C den maximalen Wert erreicht hat und gleichzeitig mittels des Schaltelementes K4 die Spannungsquelle SP mit dem Schwingkreis zu verbinden und die Verbindung zwischen Spule L und Kondensator C und dem Widerstand R mittels des Schaltelementes K5 zu lösen, damit über die beiden passiven Bauelemente kein Strom fließt. Von der Steuereinheit ST wird die Spannung der Spannungsquelle SP entsprechend der Höhe der am Kondensator C anliegenden Spannung eingestellt. Wird die Steuereinheit ST erneut getriggert, wird von der Steuereinheit ST mittels dem Schaltelement K4 die Spannungsquelle SP von dem Schwingkreis getrennt und mittels des Schaltelementes K5 die Verbindung zwischen einerseits dem Kondensator C und andererseits der Spule L und dem Widerstand R wiederhergestellt und die Erregung des Schwingkreises in dem Zeitpunkt fortgesetzt, daß der Schwingkreis mit seiner maximalen Amplitude weiterschwingen kann. Sofern der Kondensator C nur sehr geringe Leckströme aufweist und die Erregung des Schwingkreises nur kurzzeitig ausgesetzt wird, kann das Anklemmen der Spannungsquelle SP entfallen. Damit kann das Schaltelement K4 und ein Steuerausgang der Steuereinheit ST entfallen, wodurch sich die Schaltungsanordnung erheblich vereinfacht.

Bei den angeführten Ausführungsformen lassen sich als Schaltelemente besonders vorteilhaft Transistoren, insbesondere MOS Transistoren verwenden. Ferner können die Strom- und Spannungsquellen auch als nicht steuerbare Quellen ausgeführt werden, sofern die Größe der Strom- und Spannungsamplituden im Schwingkreis hinreichend konstant sind. In diesem Zusammenhang sei darauf hingewiesen, daß das erfindungsgemäße Verfahren keine besondere Anforderungen an die Spannungs- und Stromquellen stellt.

Besonders vorteilhaft läßt sich das erfindungsgemäße Verfahren in Systemen zur drahtgebundenen und drahtlosen Datenübertragung einsetzen, da bei den im intermittierenden Betrieb arbeitenden Schwingkreisen die Datenübertragungsrate durch die verkürzten Sendepausen erheblich gesteigert wird. Ferner wird bei Verwendung des erfindungsgemäßen Verfahrens bei den kontaktlosen Idenifikationsystemen der Authentifizierungsprozeß schneller abgeschlossenen, wobei aufgrund der eigenen Energieversorgung die bevorzugte Anwendung in der Basiseinheit gegeben ist. Durch die verkürzten Sendepausen wird ein höherer Energieübertrag von der Basiseinheit auf die Transponder ermöglicht, weshalb deren Kommunikationsabstand steigt.

Da die Datenübertragungsrate durch die Vermeidung der Übergangszustände nicht mehr absinkt, läßt sich im Bereich der kontaktlosen Identifikationssysteme in Sende- und Empfangsanlagen auch mit Schwingkreises hoher Güte d.h. im Bereich von 100 arbeiten. Nach dem bisherigen Stand der Technik hatten sich nach Gleichung (2) für Frequenzen um 100 kHz Abklingzeiten im Bereich von einigen Millisekunden ergeben und waren deshalb für diesen Bereich nur schwierig einsetzbar. Mit dem erfindungsgemäßen Verfahren lassen sich Schwingkreise großer Güte verwenden und damit aus den geringen Versorgungsspannungen der Basiseinheiten Amplituden von über 100 V im Sendekreis zu erzeugen. Bei den auf induktiven Wege versorgten Transponder steigt damit der Energieübertrag und folglich der Kommunikationsabstand zur Basiseinheit.

**Patentansprüche**

1. Verfahren zum Reduzieren der Abkling- und Einschwingzeiten einer charakteristischen physikalischen Größe, wie einer Spannung, bei im intermittierenden Betrieb arbeitenden erregten Schwingkreisen mit wenigstens einem Kondensator (C) und wenigstens einer mit dem Kondensator (C) verbundenen Spule (L),
**dadurch gekennzeichnet, dass**
eine Erregung des Schwingkreises in einem Zeitpunkt abgeschaltet wird, wenn die Spannung am Kondensator (C) einen maximalen Wert erreicht hat, dass mit dem Abschalten der Erregung die Verbindung zwischen der Spule (L) und dem Kondensator (C) aufgetrennt wird und dass
mit dem Einschalten der Erregung die Spule (L) wieder mit dem Kondensator (C) verbunden wird.

2. Verfahren nach Anspruch 1, **dadurch gekennzeichnet, dass** mit dem Abschalten der Erregung die Spannung an dem Kondensator (C) durch Verbinden desselben mit einer Spannungsquelle (SP) auf dem maximalen Wert gehalten wird, und dass mit dem Einschalten der Erregung die Spannungsquelle (SP) von dem Kondensator (C) getrennt wird.

3. Verwendung des Verfahrens nach einem der vorangehenden Ansprüche zur drahtlosen Datenübertragung.

**4.** Verwendung des Verfahrens nach Anspruch 1 oder 2 zur drahtgebundenen Datenübertragung.

**5.** Verwendung des Verfahrens nach einem der vorangehenden Ansprüche zur Beschleunigung der Datenübertragung bei Sende- und Empfangseinheiten.

**6.** Verwendung des Verfahrens nach einem der vorangehenden Ansprüche zur Beschleunigung der Datenübertragung zwischen einer Basiseinheit und einem Transponder.

**7.** Schaltungsanordnung zur Reduzierung der Abkling- und Einschwingzeiten einer charakteristischen physikalischen Größe, wie einer Spannung, bei im intermittierenden Betrieb arbeitenden Schwingkreisen, aufweisend:

wenigstens einen Kondensator (C);
wenigstens eine mit dem Kondensator (C) verbundene Spule (L);
eine Steuereinheit (ST), die zum Erregen des Schwingkreises ausgebildet ist; und
wenigstens ein erstes elektrisches Schaltelement (K2, K5);

**dadurch gekennzeichnet, dass**
das erste elektrische Schaltelement (K2, K5) zwischen dem Kondensator (C) und der Spule (L) angeordnet ist und dass die Steuereinheit (ST) zum Steuern des ersten elektrischen Schaltelements (K2, K5) ausgebildet ist, wobei nach Maßgabe der Steuereinheit (ST) mittels des ersten elektrischen Schaltelements (K2, K5) mit dem Abschalten der Erregung und bei Erreichen eines maximalen Werts der Spannung am Kondensator (C) ein Trennen der Verbindung zwischen dem Kondensator (C) und der Spule (L) bewirkbar ist und wobei nach Maßgabe der Steuereinheit (ST) mittels des ersten elektrischen Schaltelements (K2, K5) mit dem Einschalten der Erregung ein Wiederherstellen der Verbindung zwischen dem Kondensator (C) und der Spule (L) bewirkbar ist.

**8.** Schaltungsanordnung nach Anspruch 7, **gekennzeichnet durch** ein zweites, **durch** die Steuereinheit (ST) gesteuertes elektrisches Schaltelement (K1, K4) und **durch** eine Spannungsquelle (SP), wobei nach Maßgabe der Steuereinheit (ST) mittels des zweiten elektrischen Schaltelements (K1, K4) mit dem Abschalten der Erregung ein Verbinden des Kondensators (C) mit der Spannungsquelle (SP) bewirkbar ist und wobei nach Maßgabe der Steuereinheit (ST) mittels des zweiten elektrischen Schaltelements (K1, K4) mit dem Einschalten der Erregung ein Trennen der Verbindung zwischen dem Kondensator (C) und der Spannungsquelle (SP) bewirkbar ist.

**9.** Schaltungsanordnung nach Anspruch 8, **dadurch gekennzeichnet, dass** durch die Spannungsquelle (SP) die Spannung am Kondensator (C) auf dem maximalen Wert festgehalten ist, wobei eine Spannung der Spannungsquelle (SP) entsprechend dem maximalen Wert der Spannung am Kondensator (C) eingestellt ist.

**10.** Schaltungsanordnung nach Anspruch 8 oder 9, **dadurch gekennzeichnet, dass** die Spannung der Spannungsquelle (SP) durch die Steuereinheit (ST) gesteuert ist.

**11.** Schaltungsanordnung nach einem der Ansprüche 7 bis 10, **dadurch gekennzeichnet, dass** die Schaltelemente (K1, K2, K4, K5) als Transistoren ausgebildet sind.

**12.** Schaltungsanordnung nach einem der Ansprüche 7 bis 11, **dadurch gekennzeichnet, dass** die Schaltelemente (K1, K2, K4, K5) als MOS-Transistoren ausgebildet sind.

**13.** Schaltungsanordnung nach einem der Ansprüche 7 bis 12, **dadurch gekennzeichnet, dass** der Kondensator (C) und die Spule (L) in Reihe geschaltet sind.

**14.** Schaltungsanordnung nach einem der Ansprüche 7 bis 12, **dadurch gekennzeichnet, dass** der Kondensator (C) und die Spule (L) parallel geschaltet sind.

**15.** Verwendung der Schaltungsanordnung nach einem der Ansprüche 7 bis 14 zur drahtlosen Datenübertragung.

**16.** Verwendung der Schaltungsanordnung nach einem der Ansprüche 7 bis 14 zur drahtgebundenen Datenübertragung.

**17.** Verwendung der Schaltungsanordnung nach einem der Ansprüche 7 bis 14 zur Beschleunigung der Datenübertragung bei Sende- und Empfangseinheiten.

**18.** Verwendung der Schaltungsanordnung nach einem der Ansprüche 7 bis 14 zur Beschleunigung der Datenübertragung zwischen einer Basiseinheit und einem Transponder.

**Claims**

**1.** Method of reducing the decay and build-up times of a characteristic physical magnitude, such as a voltage, in oscillator circuits, which are excited to operate in intermittent operation, with at least one capacitor (C) and at least one coil (L) connected with the capacitor (C), **characterised in that** excitation of the oscillator circuit is switched off at a point in time when the voltage at the capacitor (C) has reached a maximum value, that with the switching off of the excitation the connection between the coil (L) and the capacitor (C) is separated and that with the switching on of the excitation the coil (11) is reconnected with the capacitor (C).

**2.** Method according to claim 1, **characterised in that** with the switching off of the excitation the voltage at the capacitor (C) is kept at the maximum value by connection of the capacitor with a voltage source (ST) and that with the switching on of the excitation the voltage source (SP) is separated from the capacitor (C).

**3.** Use of the method according to one of the preceding claims for wire-free data transmission.

**4.** Use of the method according to claim 1 or claim 2 for wire-bound data transmission.

**5.** Use of the method according to one of the preceding claims for acceleration of the data transmission in transmitting and receiving units.

**6.** Use of the method according to one of the preceding claims for acceleration of the data transmission between a base unit and a transponder.

**7.** Circuit arrangement for reducing the decay and build-up times of a characteristic physical magnitude, such as a voltage, in oscillator circuits operating in intermittent operation, comprising:

   at least one capacitor (C);
   at least one coil (L) connected with the capacitor;
   a control unit (ST) constructed for excitation of the oscillator circuit; and
   at least one first electrical switching element (K2, K5);

   **characterised in that** the first electrical switching element (K2, K5) is arranged between the capacitor (C) and the coil (L) and that the control unit (ST) is constructed for controlling the first electrical switching element (K2, K5), wherein separation of the connection between the capacitor (C) and the coil (11) can be produced according to the control unit (ST) by means of the first electrical switching element (K2, K5) when the excitation is switched off and on attainment of a maximum value of the voltage at the capacitor (C) and wherein reinstatement of the connection between the capacitor (C) and the (L) can be produced according to the control unit (ST) by means of the first electrical switching element (K2, K5) when the excitation is switched on.

**8.** Circuit arrangement according to claim 7, **characterised by** a second electrical switching element (K1, K4) controlled by the control unit (ST) and by a voltage source (SP), wherein a connection of the capacitor (C) with the voltage source (SP) can be produced according to the control unit (ST) by means of the second electrical switching element (K1, K4) when the excitation is switched off and wherein separation of the connection between the capacitor (C) and the voltage source (SP) can be produced according to the control unit (ST) by means of the second electrical switching element (K1, K4) when the excitation is switched on.

**9.** Circuit arrangement according to claim 8, **characterised in that** the voltage at the capacitor (C) is fixed to the maximum value by the voltage source (SP), wherein a voltage of the voltage source (SP) is set in correspondence with the maximum value of the voltage at the capacitor (C).

**10.** Circuit arrangement according to claim 8 or 9, **characterised in that** the voltage source (SP) is controlled by the control unit (ST).

**11.** Circuit arrangement according to one of claims 7 to 10, **characterised in that** the switching elements (K1, K2, K4, K5) are constructed as transistors.

12. Circuit arrangement according to one of claims 7 to 101 **characterised in that** the switching elements (K1, K2, K4, K5) are constructed as MOS transistors.

13. Circuit arrangement according to one of claims 7 to 12, **characterised in that** the capacitor (C) and the coil (L) are connected in series.

14. Circuit arrangement according to one of claims 7 to 12, **characterised in that** the capacitor (C) and the coil (L) are connected in parallel.

15. Use of the circuit arrangement according to one of claims 7 to 14 for wire-free data transmission.

16. Use of the circuit arrangement according to one of claims 7 to 14 for wire-bound data transmission.

17. Use of the circuit arrangement according to one of claims 7 to 14 for acceleration of the data transmission in transmitting and receiving units.

18. Use of the circuit arrangement according to one of claims 7 to 14 for acceleration of the data transmission between a base unit and a transponder.

**Revendications**

1. Procédé de réduction des durées d'amortissement et des transitoires d'une grandeur physique caractéristique, telle une tension, dans des circuits oscillants à fonctionnement intermittent comportant au moins un condensateur (C) et au moins une bobine (L) reliée au condensateur (C),
   **caractérisé en ce que** :

   une excitation du circuit oscillant est interrompue à un moment où la tension au niveau du condensateur (C) a atteint une valeur maximale, **en ce que** l'interruption de l'excitation coupe la liaison entre la bobine (L) et le condensateur (C),
   et **en ce que** l'application de l'excitation rétablit la liaison entre la bobine (L) et le condensateur (C).

2. Procédé selon la revendication 1, **caractérisé en ce que** par la déconnexion de l'excitation, on maintient la tension du condensateur (C) au niveau maximal par la liaison de ce dernier avec une source de tension (SP), et **en ce que** l'excitation provoque l'ouverture de la liaison entre la source de tension (SP) et le condensateur (C).

3. Utilisation du procédé selon l'une quelconque des revendications précédentes pour la transmission sans fil de données.

4. Utilisation du procédé selon la revendication 1 ou 2 pour la transmission par fil de données.

5. Utilisation du procédé selon l'une quelconque des revendications précédentes pour l'accélération de la transmission de données dans des unités d'émission et de réception.

6. Utilisation du procédé selon l'une quelconque des revendications précédentes pour l'accélération de la transmission de données entre une unité de base et un transpondeur.

7. Circuit de réduction des durées d'amortissement et des transitoires d'une grandeur physique caractéristique, telle une tension, dans des circuits oscillants à fonctionnement intermittent, comprenant :

   au moins un condensateur (C) ;
   au moins une bobine (L) reliée à un condensateur (C) ;
   une unité de commande (ST) conçue pour l'excitation du circuit oscillant ; et
   au moins un premier élément de commutation (K2, K5) électrique ;
   **caractérisé en ce que**
   le premier élément de commutation (K2, K5) électrique est disposé entre le condensateur (C) et la bobine (L) et **en ce que** l'unité de commande (ST) est conçue pour commander le premier élément de commutation (K2, K5) électrique, circuit permettant, en raison de l'unité de commande (ST) par l'intermédiaire du premier élément de commutation (K2, K5) électrique, lorsque l'on interrompt l'excitation et lorsque la valeur de la tension est maximale aux bornes du condensateur (C), de provoquer une ouverture de la liaison entre le condensateur (C) et la bobine (L), et permettant en raison de l'unité de commande (ST) par l'intermédiaire du premier élément de commutation (K2, K5) électrique, lorsque l'on applique l'excitation, un rétablissement de la liaison entre le condensateur (C) et la bobine (L).

8. Circuit selon la revendication 7, **caractérisé par** un deuxième élément de commutation (K1, K4) électrique commandé par l'unité de commande (ST), et par une source de tension (SP), circuit permettant, en raison de l'unité de commande (ST) par l'intermédiaire du deuxième élément de commutation (K1, K4) électrique, lorsque l'on interrompt l'excitation, d'établir une liaison entre le condensateur (C) et la source de tension (SP), et permettant en raison de l'unité de commande (ST) par l'intermédiaire du deuxième élément de commutation (K1, K4) électrique, lorsque l'on applique l'excitation, d'ouvrir la liaison entre le condensateur (C) et la source de tension (SP).

9. Circuit selon la revendication 8, **caractérisé en ce que** la tension au niveau du condensateur (C) est maintenue à sa valeur maximale par la source de tension (SP), circuit dans lequel on définit une tension de la source de tension (SP) correspondant à la valeur maximale de la tension au niveau du condensateur (C).

10. Circuit selon la revendication 8 ou 9, **caractérisé en ce que** la tension de la source de tension (SP) est commandée par l'unité de commande (ST).

11. Circuit selon l'une quelconque des revendications 7 à 10, **caractérisé en ce que** les éléments de commutation (K1,K2,K4,K5) sont des transistors.

12. Circuit selon l'une quelconque des revendications 7 à 11, **caractérisé en ce que** les éléments de commutation (K1,K2,K4,K5) sont des transistors MOS.

13. Circuit selon l'une quelconque des revendications 7 à 12, **caractérisé en ce que** le condensateur (C) et la bobine (L) sont montés en série.

14. Circuit selon l'une quelconque des revendications 7 à 12, **caractérisé en ce que** le condensateur (C) et la bobine (L) sont montés en parallèle.

15. Utilisation du circuit selon l'une quelconque des revendications 7 à 14 pour la transmission sans fil de données.

16. Utilisation du circuit selon l'une quelconque des revendications 7 à 14 pour la transmission par fil de données.

17. Utilisation du circuit selon l'une quelconque des revendications 7 à 14 pour l'accélération de la transmission de données dans des unités d'émission et de réception.

18. Utilisation du circuit selon l'une quelconque des revendications 7 à 14 pour l'accélération de la transmission de données entre une unité de base et un transpondeur.

FIG.1

FIG.2

FIG.3

FIG.4